# EUROPÄISCHE PATENTSCHRIFT

(11) **EP 1 389 337 B1**
(45) Veröffentlichungstag und Bekanntmachung des Hinweises auf die Patenterteilung: **20.07.2005**
(21) Anmeldenummer: 02730255.3
(22) Anmeldetag: 15.05.2002
(51) Int. Cl.: G12B 9/04, F16B 33/06

(54) **ANORDNUNG AUS EINEM METALLISCHEN DECKEL UND EINEM METALLISCHEM GEHÄUSE EINES MESSGERÄTES UND VERFAHREN ZU DEREN HERSTELLUNG**
ARRANGEMENT OF A METAL LID AND A METAL HOUSING FOR A MEASURING DEVICE AND METHOD FOR PRODUCTION THEREOF
ENSEMBLE CONSTITUE D'UN COUVERCLE METALLIQUE ET D'UN BOITIER METALLIQUE POUR UN DISPOSITIF DE MESURE ET PROCEDE DE FABRICATION DUDIT ENSEMBLE

(30) Priorität: 21.05.2001 DE 10124933
(43) Veröffentlichungstag der Anmeldung: 18.02.2004
(73) Patentinhaber: Endress + Hauser GmbH + Co. KG, 79689 Maulburg (DE)
(72) Erfinder: WENDLER, Armin, 79111 Freiburg (DE)
(74) Vertreter: Andres, Angelika
(86) Internationale Anmeldenummer: PCT/EP2002/005337
(87) Internationale Veröffentlichungsnummer: WO 2002/095764

(56) Entgegenhaltungen:
- US-A- 4 114 505
- US-A- 5 028 117
- US-A- 5 121 188
- US-A- 5 353 200
- US-A- 6 053 914

## Beschreibung

Die Erfindung betrifft eine Anordnung aus einem Deckel aus einem metallischen Werkstoff und einem metallischem Gehäuse eines Meßgerätes und ein Verfahren zu deren Herstellung.

Derartige Anordnungen sind insbesondere für Feldmeßgeräte der Prozeßmeß- und -Steuertechnik bekannt, mit denen z.B. eine physikalische Zustandsvariable eines am Prozeß beteiligten Mediums erfaßt werden soll. Die Erfassung solcher Variablen ist an sich bekannt und nicht Gegenstand dieser Erfindung.

Solche Anordnungen sind meist in der Nähe des Prozesses oder des zu messenden Mediums installiert und häufig den dort herrschenden ungünstigen Prozeßbedingungen, wie z.B. hohen Umgebungstemperaturen und starker Verschmutzung oder auch Regen, Wind, Staub, Schnee und Eis bei einer Installation im Freien ausgesetzt.

Es hat sich gezeigt, daß die üblicherweise verwendeten Schraubverbindungen von einem metallischem Deckel auf ein metallisches Gehäuse zum sogenannten Fressen neigen. Die lassen sich nach einer gewissen Zeit nicht mehr oder nicht ohne erheblichen Aufwand lösen und können in einzelnen Fällen nur noch aufgebrochen oder aufgeschnitten werden.

Eine bisher verwendete Maßnahme, das Fressen der Schraubverbindungen zu verhindern, ist die vollständige Beschichtung von Deckel und Gehäuse, wobei je nach metallischem Werkstoff, aus dem Deckel bzw. Gehäuse bestehen, Nickel-, Gleitlack- oder eine sonstige Pulverbeschichtung oder eine Eloxal- bzw. Harteloxal-Beschichtung angewendet wird. Ein übliches Verfahren dazu ist ein Tauchbad mit einer die Beschichtung ergebenden Flüssigkeit, in das die zu beschichtenden Teile vollständig eingetaucht werden. Dort, wo bei bisherigen Deckeln bzw. Gehäusen keine Beschichtung gewünscht wird, ist vor dem Tauchen in das Beschichtungsbad die betreffende Teilfläche abzudecken, sei es mit einem Lack oder sei durch Abdecken mit einer aufgeklebten Folie. Nach dem Beschichtungs-Tauchbad muß üblicherweise die Abdeckung wieder entfernt werden, was nicht nur einen zusätzlichen Arbeitsschritt sondern auch einen zusätzlichen Aufwand eines Lösungsmittels erfordert.

Darüber hinaus ist festzustellen, daß eine vollständige Beschichtung von Deckel und Gehäuse aufwendig, teuer und wenig umweltfreundlich ist, weil sie eine lange Verweildauer der zu beschichtenden Teile im Beschichtungsprozeß erfordern.

Der Erfindung liegt daher die Aufgabe zugrunde, eine Anordnung aus einem miteinander verschraubten Deckel aus einem metallischen Werkstoff und einem metallischem Gehäuse für ein Meßgerät zu schaffen, bei dem auch unter widrigen Umständen die Schraubverbindung lösbar bleibt, die aber darüber hinaus einfach zu verwirklichen, preiswert und umweltfreundlich ist und bei der die oben geschilderten Nachteile vermieden werden.

Diese Aufgabe wird gelöst durch eine erste Variante einer Anordnung aus einem Deckel aus einem metallischen Werkstoff und einem metallischem Gehäuse eines Meßgerätes nach der Erfindung, wobei der Deckel und das Gehäuse mit einem Gewinde versehen sind, so daß der Deckel in bzw. auf das Gehäuse geschraubt werden kann und der Deckel nur an wenigsten einer vorgegebenen Teilfläche, insbesondere im Bereich seines Gewindes mit einer Beschichtung versehen ist, die ein Fressen des Gewindes verhindert.

Diese Aufgabe wird außerdem gelöst durch eine zweite Variante einer Anordnung aus einem Deckel aus einem metallischen Werkstoff und einem metallischem Gehäuse eines Meßgerätes nach der Erfindung, wobei der Deckel und das Gehäuse mit einem Gewinde versehen sind und der Deckel in bzw. auf das Gehäuse geschraubt und wobei das Gehäuse nur an wenigsten einer vorgegebenen Teilfläche, insbesondere im Bereich seines Gewindes mit einer derartigen Beschichtung versehen ist, die ein Fressen des Gewindes verhindert.

Bei weiteren Ausführungen der Anordnung nach der Erfindung ist vorgesehen, daß die Beschichtung elektrisch isolierend ist.

Andere Ausführungsformen der Erfindung betreffen eine Beschichtung aus einer Eloxalschicht.

Noch andere Ausführungsformen der Anordnung nach der Erfindung betreffen eine elektrische Verbindung zwischen Deckel und Gehäuse.

Bei noch einer weiteren Ausführung der Erfindung ist die Beschichtung in der Zone ausgespart, wo die elektrische Kontaktierung zwischen Deckel und Gehäuse gewünscht ist.

Eine weitere Ausführungsform der Anordnung nach der Erfindung betrifft eine Beschichtung, die ausschließlich im Bereich des Gewindes ausgeführt ist.

Eine zusätzliche Ausführung der Erfindung ist ein Verfahren zur Herstellung einer Beschichtung für eine Anordnungen nach der Erfindung, wobei ein zur Beschichtung dienendes Medium ausschließlich auf die zu beschichtenden Bereiche einwirkt.

Bei einer weiteren Ausführung des Verfahrens nach der Erfindung wirkt das zur Beschichtung dienende Medium nur auf das Gewinde ein.

Die besonderen mit der Erfindung erzielbaren Vorteile sind darin zu sehen, daß bei der vorgestellten Anordnung nur dort eine Beschichtung aufgebracht wird, wo sie wirklich erforderlich ist. Das spart Energie und Beschichtungsmaterial, weil keine überflüssige Beschichtung aufgebracht. Die Verweilzeiten für die zu beschichtenden Teile im Beschichtungsprozeß sind verkürzt: Nachträgliches Entfernen von Abdeckungen an den Stellen, wo an sich keine Beschichtung gewünscht wird, ist nicht mehr erforderlich. Da die zu beschichtenden Teile nicht mehr vollständig in ein Tauchbad getaucht werden müssen, sind das Verfahren und die damit beschichteten Deckel bzw. Gehäuse preiswert, schnell und umweltfreundlich. Es ist sogar möglich vormontierte Teile zu beschichten, da die Beschichtung nur dort erfolgt, wo sie wirklich gewünscht wird. Es werden weder die nicht zu beschichtenden Teile beeinflußt noch wird die Beschichtung beeinflußt.

Die Erfindung wird nachfolgend anhand eines Ausführungsbeispiels und unter Zuhilfenahme von Zeichnungen beschrieben und erläutert. Dabei zeigen:
Fig. 1: eine schematische Schnittdarstellung einer ersten Ausführung eines Gehäuses mit aufgeschraubtem Deckel für ein Meßgerät;
Fig. 2: eine schematische Schnittdarstellung eines Deckel einer anderen Ausführungsform der Erfindung; und
Fig. 3: eine schematische Schnittdarstellung eines Gehäuses einer weiteren Ausführungsform der Erfindung

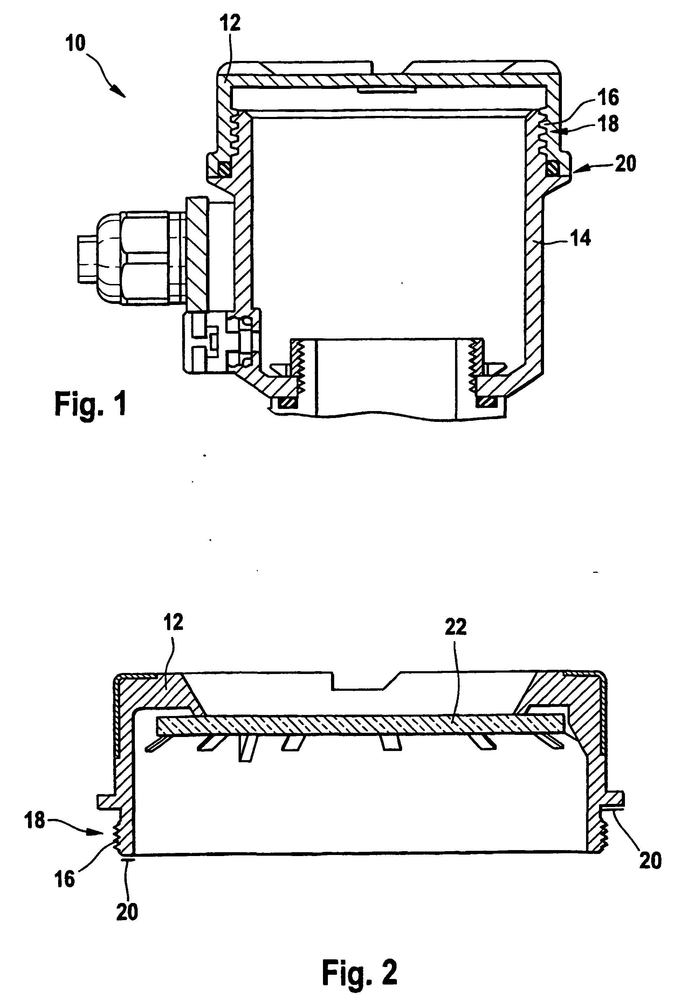

In Fig. 1 ist eine erste Ausführungsform einer Anordnung 10 nach der Erfindung dargestellt. Bei dieser Darstellung ist zur Veranschaulichung ein Deckel 12 mit einem Gehäuse 14 verschraubt. Der Deckel 12 und auch das Gehäuse 14 weisen zu diesem Zweck entsprechende Schraubgewinde, die in Fig. 1 mit "16" bezeichnet sind. Der Deckel 12 und das Gehäuse 14 sind aus einem metallischen Werkstoff gefertigt, aber es ist nicht zwingend, daß sie beide aus dem gleichen Werkstoff bestehen. Vorzugsweise wird jedoch der Deckel 12 aus Aluminium hergestellt.

Im Bereich der Gewinde 16 sind entweder der Deckel 12 oder das Gehäuse 14 mit einer Beschichtung 18 versehen, vorzugsweise eine Eloxal-Beschichtung, die das Fressen der Gewinde 16 verhindert. Für andere Anwendungsfälle und/oder andere Werkstoffe für den Deckel 12 bzw. das Gehäuse 14 sind auch andere Beschichtung gegen das Fressen denkbar. Genauso ist es auch ohne Einschränkung der Erfindung möglich, sowohl den Deckel 12 als auch das Gehäuse 14 im Bereich ihrer Gewinde 16 zu beschichten.

Die Beschichtung erfolgt nicht in einem Tauchbad mit einer geeigneten Beschichtungsflüssigkeit, in das der Deckel 12 bzw. das Gehäuse 14 vollständig eingetaucht werden, sondern erfolgt quasi punktuell, indem die Beschichtungsflüssigkeit nur an bzw. auf die Stellen des Deckels 12 und/oder des Gehäuses 14 aufgebracht wird, wo die Beschichtung gewünscht ist. Andere Stellen oder Teilflächen des Deckels 12 bzw. des Gehäuses 14 als die dafür vorgesehenen werden von der Beschichtungsflüssigkeit nicht berührt oder beeinflußt.

Fig. 2 veranschaulicht in einer vergrößerten schematischen Schnittdarstellung ein anderes Ausführungsbeispiels eines metallischen Deckels 12 für eine Anordnung nach der Erfindung. Bei diesem Deckel 12 ist das Gewinde 16 als Außengewinde ausgeführt auf jenem Teil des Deckels 12 der in eine mit einem entsprechenden Innengewinde versehenen Öffnung eines Gehäuses eingeschraubt wird. Da der hier dargestellte Deckel 12 mit dem metallischen Gehäuse eine elektrisch leitende Verbindung haben soll, ist in dafür vorgesehenen Bereichen 20, an Kanten bzw. Schultern der Deckels 12 die Beschichtung 18, die nur im Bereich des Gewindes 16 aufgetragen ist, ausgespart. Eine bei dem in Fig. 2 dargestellten Deckel 12 vorgesehene durchsichtige Platte bzw. Scheibe 22 kann bereits vor dem eigentlichen Beschichten des Deckels 12 montiert werden und wird durch die Beschichtung nicht beeinflußt. Auch hier wird die Beschichtung auf den Bereich des Gewindes 16 beschränkt.

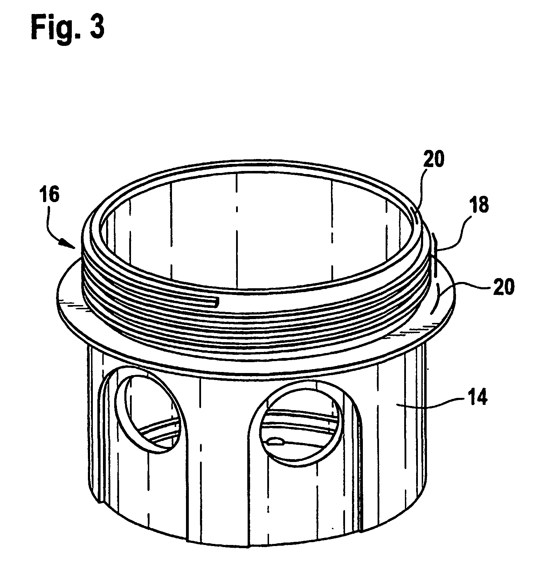

Das in Fig. 3 für sich dargestellte metallische Gehäuse 14 veranschaulicht noch einmal einen Bereich des Gewindes 16, der der einzige Bereich oder Teilfläche auf dem Gehäuse 12 ist, die mit der Beschichtung gegen Fressen beschichtet ist. Ähnlich dem in Fig. 2 dargestellten Deckel 12 ist bei diesem Gehäuse 14, das an sich für einen anderen Deckel gedacht ist, eine elektrische Kontaktierung zwischen einem Deckel und dem Gehäuse 14 vorgesehen und zwar in den Bereichen 20, also bei solchen Schultern des Gehäuses 14, die in direkten mechanischen Kontakt zu einem aufgeschraubten Deckel stehen. Um den direkten physikalischen und den gewünschten elektrischen Kontakt nicht zu verhindern, ist die Beschichtung an diesen Zonen 20 ausgespart.

## Patentansprüche

1. Anordnung aus einem Deckel (12) aus einem metallischen Werkstoff und einem metallischem Gehäuse (14) eines Meßgerätes, wobei der Deckel (12) und das Gehäuse (14) mit einem Gewinde (16) versehen sind und der Deckel (12) nur an wenigsten einer vorgegebenen Teilfläche, beschränkt auf den Bereich seines Gewindes (16) mit einer Beschichtung (18) versehen ist, die ein Fressen des Gewindes (16) verhindert.

2. Anordnung aus einem Deckel (12) aus einem metallischen Werkstoff und einem metallischem Gehäuse (14) eines Meßgerätes, wobei der Deckel (12) und das Gehäuse (14) mit einem Gewinde (16) versehen sind und der Deckel (12) in bzw. auf das Gehäuse (14) geschraubt und wobei das Gehäuse (14) nur an wenigsten einer vorgegebenen Teilfläche, beschränkt auf den Bereich seines Gewindes (16) mit einer Beschichtung (18) versehen ist, die ein Fressen des Gewindes (16) verhindert.

3. Anordnung nach Anspruch 1 oder 2, bei dem die Beschichtung (18) elektrisch isolierend ist.

4. Anordnung nach Anspruch 3, bei dem die Beschichtung (18) eine Eloxalschicht ist.

5. Anordnung nach einem der vorgehenden Ansprüche, bei dem zwischen Deckel (12) und Gehäuse (14) eine elektrische Verbindung hergestellt ist.

6. Anordnung nach Anspruch 5, bei dem die Beschichtung in einer Zone (20) ausgespart ist, wo die elektrische Kontaktierung zwischen Deckel (12) und Gehäuse (14) gewünscht ist.

7. Anordnung nach einen der vorgehenden Ansprüche, bei dem die Beschichtung (18) ausschließlich im Bereich des Gewindes (16) ausgeführt ist.

8. Verfahren zur Herstellung einer Beschichtung (18) für eine der Anordnungen nach den Ansprüchen 1 bis 7, wobei ein zur Beschichtung dienendes Medium ausschließlich auf die zu beschichtenden Bereiche einwirkt.

9. Verfahren nach Anspruch 8, bei dem das zur Beschichtung dienende Medium nur auf das Gewinde (16) einwirkt.

## Claims

1. An arrangement of a lid (12) made of a metallic material and a metallic housing (14) of a measuring instrument, wherein the lid (12) and the housing (14) are provided with a screw thread (16), and the lid (12) is provided only on at least one prescribed partial surface, limited to the region of its screw thread (16), with a coating (18) which prevents seizing of the screw thread (16).

2. An arrangement of a lid (12) made of a metallic material and a metallic housing (14) of a measuring instrument, wherein the lid (12) and the housing (14) are provided with a screw thread (16), and the lid (12) is screwed into or onto the housing (14), and wherein the housing (14) is provided only on at least one prescribed partial surface, limited to the region of its screw thread (16), with a coating (18) which prevents seizing of the screw thread (16).

3. An arrangement according to Claim 1 or 2, in which the coating (18) is electrically insulating.

4. An arrangement according to Claim 3, in which the coating (18) is an eloxal layer.

5. An arrangement according to one of the preceding claims, in which an electrical connection is established between the lid (12) and the housing (14).

6. An arrangement according to Claim 5, in which the coating is omitted in a zone (20) where the electrical contacting is desired between the lid (12) and the housing (14).

7. An arrangement according to one of the preceding Claims, in which the coating (18) is effected solely in the region of the screw thread (16).

8. A method for producing a coating (18) for one of the arrangements according to Claims 1 to 7, wherein a medium serving for the coating acts solely on the regions to be coated.

9. A method according to Claim 8, in which the medium serving for the coating acts only on the screw thread (16).

## Revendications

1. Dispositif constitué d'un couvercle (12) dans un matériau métallique et un boîtier (14) métallique d'un appareil de mesure ; le couvercle (12) et le boîtier (14) étant pourvus d'un filetage (16) et le couvercle (12) étant pourvu uniquement sur une surface prédéterminée au moins, limitée à la zone de son filetage (16), d'un revêtement (18) qui empêche le pourrissement du filetage (16).

2. Dispositif constitué d'un couvercle (12) dans un matériau en métal et d'un boîtier (14) métallique d'un appareil de mesure ; le couvercle (12) et le boîtier (14) étant pourvus d'un filetage (16) et le couvercle (12) étant vissé dans, respectivement sur le boîtier (14) et où le boîtier (14)) étant pourvu uniquement sur une surface prédéterminée au moins, limitée à la zone de son filetage (16), d'un revêtement (18) qui empêche le pourrissement du filetage (16).

3. Dispositif selon la revendication 1 ou 2, où le revêtement (18) est un isolant électrique.

4. Dispositif selon la revendication 3, où le revêtement (18) est une couche d'éloxale.

5. Dispositif selon une des revendications précédentes, où on a fabriqué une liaison électrique entre le couvercle (12) et le boîtier (14).

6. Dispositif selon la revendication 5, où on économise le revêtement dans une zone (20) où le contact électrique est souhaité entre le couvercle (12) et le boîtier (14).

7. Dispositif selon une des revendications précédentes, où le revêtement (18) est réalisé exclusivement dans la zone du filetage (16).

8. Procédé pour la fabrication d'un revêtement (18) pour un des dispositifs selon les revendications 1 à 7, où un médium servant au revêtement agit exclusivement sur les zones à recouvrir.

9. Procédé selon la revendication 8, où le médium servant au revêtement agit uniquement sur le filetage (16).
